Europäisches Patentamt

European Patent Office

Office européen des brevets

(11) Numéro de publication : **0 071 511**
**B1**

## FASCICULE DE BREVET EUROPÉEN

(45) Date de publication du fascicule du brevet :
**16.04.86**

(51) Int. Cl.⁴ : **H 03 K   3/84**

(21) Numéro de dépôt : **82401312.2**

(22) Date de dépôt : **12.07.82**

(54) Générateur d'événements à taux d'occurrence et distribution prédéterminés.

(30) Priorité : **17.07.81 FR 8114372**

(43) Date de publication de la demande :
**09.02.83 Bulletin 83/06**

(45) Mention de la délivrance du brevet :
**16.04.86 Bulletin 86/16**

(84) Etats contractants désignés :
**DE GB IT NL**

(56) Documents cités :
**US-A- 3 946 215**

(73) Titulaire : **Urien, Michel**
**rue du Park Moan Brélevenez**
**F-22300 Lannion (FR)**

**Theron, Guy Marie Pierre Jean**
**42 rue de Lorraine**
**F-22300 Lannion (FR)**

(72) Inventeur : **Urien, Michel**
**rue du Park Moan Brélevenez**
**F-22300 Lannion (FR)**
Inventeur : **Theron, Guy Marie Pierre Jean**
**42 rue de Lorraine**
**F-22300 Lannion (FR)**

(74) Mandataire : **Le Guen, Louis François**
**Cabinet Louis Le Guen 1, avenue Edouard VII B.P. 91**
**F-35802 Dinard Cédex (FR)**

Jouve, 18, rue St-Denis, 75001 Paris, France

## Description

La présente invention concerne un générateur électronique d'événements ayant un taux d'occurrence prédéterminé, avec une distribution prédéterminée des événements.

Les générateurs connus d'événements, tels que celui décrit dans le document US-A-3 946 215, ne permettent que de choisir le taux d'occurrence de ces événements. En général, ces générateurs sont constitués par un registre de n bascules bouclées par des circuits de réaction bien connus pour délivrer des séquences d'impulsions pseudo-aléatoires. La longueur de la séquence produite est de $(2^n - 1)$ et le taux d'occurrence des événements est égal à 0,5. Ce taux d'occurrence peut être modifié en effectuant des divisions. Toutefois, ces générateurs connus ne permettent pas de provoquer l'apparition d'événements rapprochés, éventuellement consécutifs, avec un taux d'occurrence faible.

Un objet de l'invention consiste à prévoir un générateur électronique d'événements capable de délivrer des séquences d'événements pouvant être rapprochés dans le temps, mais pouvant se produire avec un taux d'occurrence faible. Dans le cas d'une application dans le domaine des télécommunications, le générateur permet d'engendrer des événements du type « paquets d'erreurs », comme on en rencontre réellement en transmission de données.

Un autre objet de l'invention consiste à prévoir un générateur pour lequel le taux d'occurrence des événements peut être choisi parmi un certain nombre de valeurs possibles et pour lequel, indépendamment, l'occurrence de certaines distances entre événements peut être favorisée.

Un autre objet de l'invention consiste aussi à prévoir un générateur pour lequel le taux d'occurrence des événements peut être choisi arbitrairement et pour lequel les distances entre événements successifs sont pseudo-aléatoires.

Les objets de l'invention mentionnés ci-dessus, ainsi que d'autres, sont atteints par la mise en œuvre des combinaisons de moyens définies dans la partie caractérisante de la revendication principale, complétée par les revendications dépendantes.

Les objets et caractéristiques de l'invention apparaîtront plus clairement à la lecture de la description suivante d'un exemple de réalisation, ladite description étant faite en relation avec les dessins joints, parmi lesquels :

la figure 1 est le schéma-bloc d'un générateur électronique d'événements suivant l'invention,

la figure 2 est un histogramme illustrant un premier mode de fonctionnement du générateur de la Fig. 1,

la figure 3 est un histogramme illustrant un second mode de fonctionnement du générateur de la Fig. 1, et

la figure 4 est le schéma bloc d'un générateur se composant d'une série de générateurs suivant la Fig. 1.

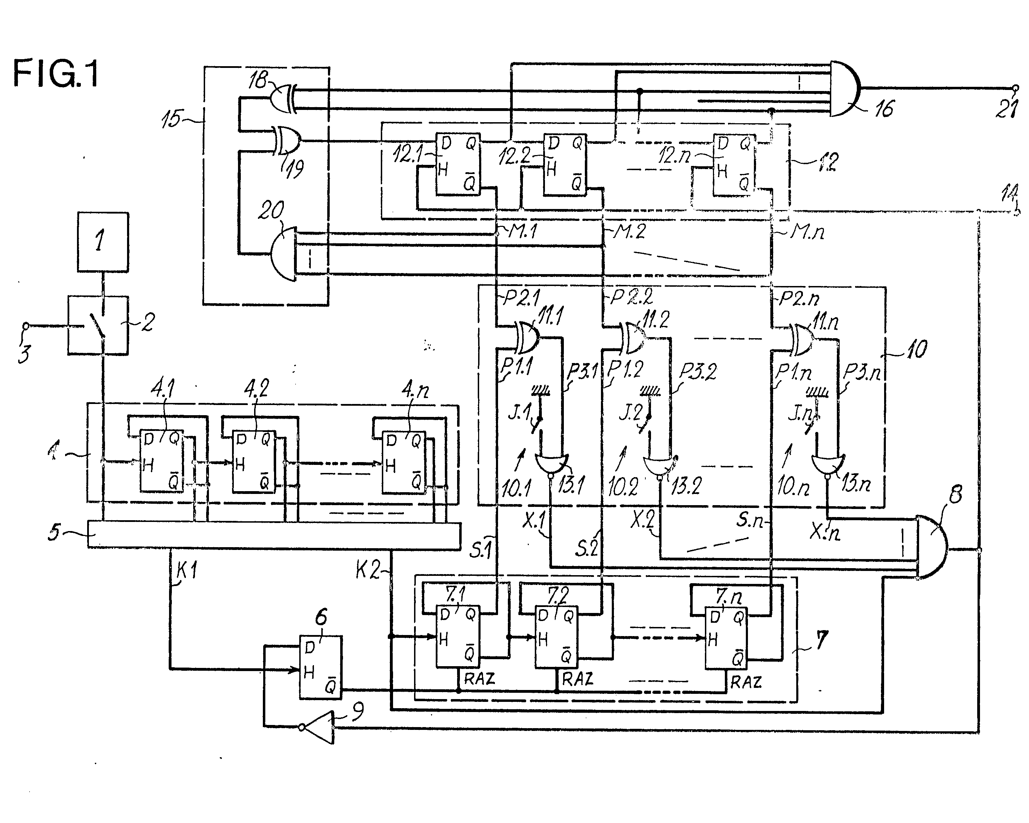

Dans le générateur de la Fig. 1, le circuit de base de temps 1 a sa sortie reliée à un contact fixe d'un inverseur 2 dont l'autre contact fixe est reliée à une borne 3 permettant un accès éventuel à une base de temps externe et dont le contact mobile est relié, d'une part, à l'entrée d'un circuit de prédivision 4 et, d'autre part, à une première entrée d'un circuit de commutation 5.

Comme le montre la Fig. 1, le circuit de prédivision 4 comporte un nombre n de bascules 4.1, 4.2, ..., 4.n montées en diviseur par deux et reliées entre elles de façon à constituer un diviseur par $2^n$ à n étages. Chaque étage du circuit 4 a ses sorties Q et Q̄ reliées à des entrées correspondantes du circuit de commutation 5. Ainsi, aux $(2^n + 1)$ entrées du circuit 5 sont appliqués le signal délivré par la base de temps 1 de période T, ainsi que les signaux de périodes $2^k T$, avec k variant de 1 à n. Le commutateur 5 comporte deux sorties K1 et K2 délivrant respectivement un signal de fréquence fo et de fréquence $fo/2^p$, avec p compris entre 1 et n. En pratique, le circuit de commutation 5 est une matrice de points de croisement ou un multiplexeur qui permet de sélecter des liaisons entre les sorties K1 et K2 et deux entrées parmi les $(2^n + 1)$ entrées possibles, les fréquences des signaux appliqués à ces entrées correspondant à fo et $fo/2^p$. La sortie K1 est reliée à l'entrée d'horloge d'une bascule 6 tandis que la sortie K2 est reliée, d'une part, à l'entrée de signal d'un compteur ou diviseur à n étages 7 et, d'autre part, à une entrée d'un circuit de coïncidence 8.

La bascule 6, figure 1, a son entrée D reliée à la sortie d'un inverseur 9 et sa sortie Q̄ reliée aux entrées de remise à zéro des n étages du diviseur 7. L'entrée de l'inverseur 9 est reliée à la sortie du circuit à coïncidence 8. La sortie Q de la bascule 6 recopie l'état de l'inverseur 9, à chaque front montant de l'impulsion de rythme délivrée par la sortie K1. La bascule 6 sert de circuit de remise à zéro pour le diviseur 7.

Comme le montre la figure 1, les étages du diviseur 7 sont des bascules 7.1, 7.2, ..., 7.n, montées en diviseur par deux l'entrée H de la bascule 7.1 étant reliée à la sortie K2 du circuit de commutation 5, sa sortie Q̄ étant reliée à son entrée D et à l'entrée H de la bascule 7.2, et sa sortie Q étant reliée à une entrée d'un circuit de programmation 10, et ainsi de suite. Ainsi, la sortie de chaque étage du diviseur 7 est reliée à une entrée correspondante du circuit 10. Les entrées RAZ des bascules 7.1 à 7.n sont reliées à la sortie Q̄ de la bascule 6.

La progression dans la suite des bascules 7.1 à 7.n est assurée par le front montant de chaque impulsion provenant de la sortie K2 et leur remise à zéro par un état bas de la sortie Q de 6.

Le circuit de programmation 10, Fig. 1, est constitué d'une chaîne de n cellules 10.1 à 10.n. Chaque cellule élémentaire 10.k est constituée par un circuit OU-exclusif 11.k dont une entrée P1.k est reliée à la sortie S.k de l'étage de rang k du diviseur 7 et dont l'autre entrée P2.k est reliée à la sortie Mk d'un registre à décalage 12 comprenant également n étages. La sortie du circuit OU-exclusif Pk est reliée à une entrée P3.k d'un circuit NON-ET 13.k à deux entrées dont la seconde entrée peut être reliée à la masse par l'intermédiaire d'un contact Jk. La sortie du circuit NON-ET 13.k est reliée par un fil Xk à une entrée correspondante du circuit à coïncidence 8.

La sortie du circuit à coïncidence 8 est, comme mentionné ci-dessus, reliée à l'entrée de l'inverseur 9 et, de plus, d'une part, aux entrées d'horloge des étages du registre à décalage 12 et, d'autre part, à la sortie 14 du générateur.

Le registre à décalage 12 se compose de n étages formés chacun d'une bascule D 12.k. Les bascules 12.1 à 12.n sont montées en série, la sortie Q de l'une étant reliée à l'entrée D de la suivante, et leurs entrées d'horloge H étant reliées en parallèle à la sortie du circuit 8. L'entrée D de la première bascule 12.1 est reliée à la sortie d'un circuit de réaction 15. Les sorties Q des bascules 12.1 à 12.n sont encore reliées en parallèle à l'entrée d'un circuit de synchronisation 16 dont la sortie est reliée à la borne 21 de sortie de synchronisation du générateur. Les sorties Q̄ des bascules 12.1 à 12.n sont respectivement reliées aux entrées P2.1 à P2.n du circuit de programmation 10, par l'intermédiaire des sorties M1 à Mn. Par ailleurs, suivant le bouclage réalisé pour que le registre à décalage 12 se comporte en générateur de séquence pseudo-aléatoire, certaines sorties Q parmi les sorties Q des bascules 12.1 à 12.n sont reliées à des entrées correspondantes du circuit de réaction 15.

A titre d'exemple, avec un registre pseudo-aléatoire à onze étages, la longueur de la séquence sera maximale pour un bouclage effectué sur les sorties Q des bascules 12.9 et 12.11.

Le circuit de réaction 15 comprend un circuit OU-exclusif 18 dont les entrées sont, dans l'exemple décrit, reliées aux sorties Q des bascules 12.9 et 12.11, et dont la sortie est reliée à une entrée d'un circuit OU-exclusif 19. La seconde entrée du circuit OU-exclusif 19 est reliée à la sortie d'un circuit ET 20 dont les entrées sont respectivement reliées aux sorties Q̄ des bascules 12.1 à 12.n. La sortie du circuit OU-exclusif 19 est reliée à l'entrée D de la bascule 12.1. Le circuit ET 20 fonctionne en circuit de départ automatique en forçant à « 1 » la sortie de 19, au cas où toutes les sorties Q des bascules 12.1 à 12.n se trouveraient à « O » lors d'une mise sous tension initiale du générateur. Le registre 12 et le circuit de réaction 15 forment un générateur de séquence pseudo-aléatoire.

Le circuit de synchronisation 16 est constitué par une porte ET qui délivre, à la borne 21, un « 1 » chaque fois que toutes les sorties Q des bascules 12.1 à 12.n sont à « 1 ». Dans le cas de l'exemple décrit, avec un registre 12 à onze étages, le circuit 16 délivre une impulsion tous les 2 047 éléments binaires. Les signaux de la sortie 21 peuvent servir de signaux de synchronisation pour un appareil récepteur, tel que par exemple celui qui a été décrit dans la demande de brevet français 80 17708 déposée par les présents demandeurs le 7 août 1981, à laquelle correspond le document EP-A-0 046 110.

Dans un premier exemple de fonctionnement du générateur, on va supposer que tous les interrupteurs J1 à J11 sont fermés. Chaque circuit NON-ET 13.1 à 13.11 a donc une de ses entrées à « 1 ». Quand le mot binaire contenu dans le registre 12 et le mot existant dans le diviseur 7 sont complémentaires, tous les circuits OU-exclusif 11.1 à 11.11 délivrent simultanément un « 1 », si bien que tous les circuits 13.1 à 13.11 délivrent un « 0 ». Les onze premières entrées du circuit à coïncidence 8 sont à « 0 » et, quand la sortie K2 délivre un signal de niveau « 0 », le circuit 8 délivre un signal de sortie qui a pour effet, premièrement, de faire changer l'état du registre 12 puisque les entrées d'horloge de ses étages reçoivent un signal, deuxièmement, de remettre à zéro le compteur 7 par l'inverseur 9 et la bascule 6 quand la sortie K1 de 5 passe à « 1 », et, troisièmement de délivrer un signal en 14, lequel constitue le signal de sortie du générateur.

On a donc à ce moment un nouveau mot dans le registre 12 et le compteur 7 qui recommence à compter à partir de zéro à la fréquence du signal de comptage délivré par la sortie K2 de 5. Quand le compte atteint dans 7 correspond au mot présent dans le registre 12, on retrouve le fonctionnement décrit ci-dessus.

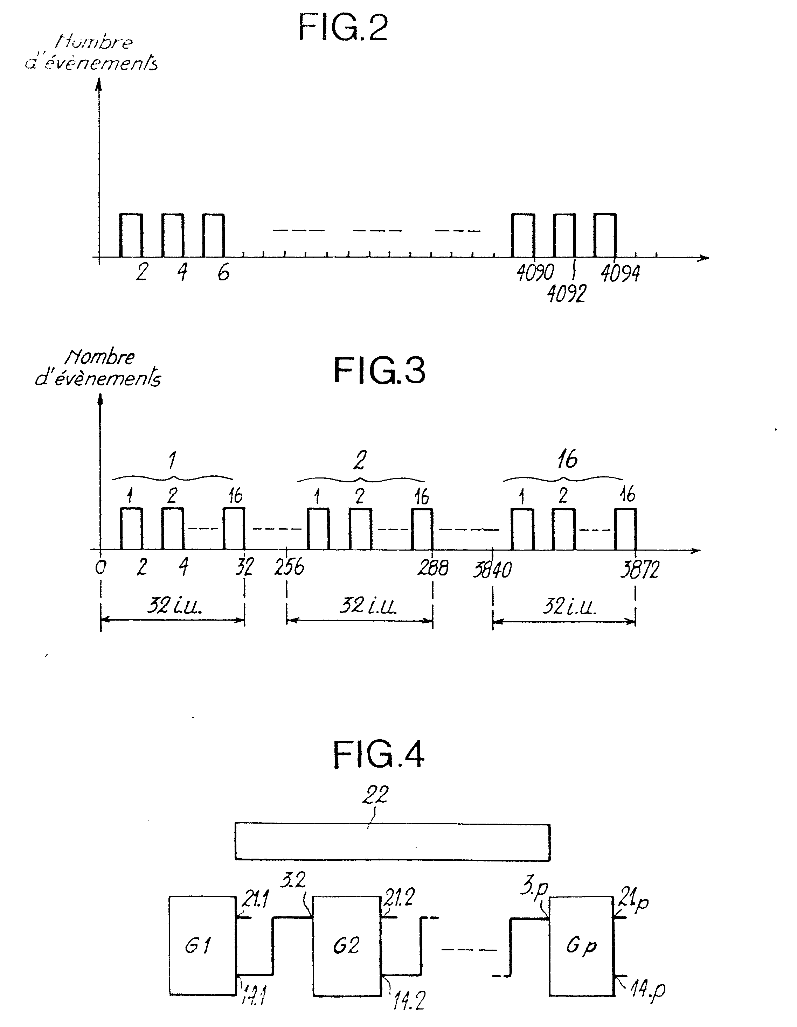

Il apparaît qu'entre deux signaux de sortie du circuit 8, il s'écoule un temps qui dépend de la valeur du mot présent dans le registre à décalage 12. Comme précisément, le registre à décalage 12 est monté en générateur de séquence pseudo-aléatoire, il apparaît que la distribution des distances entre événements à la sortie du circuit 8 va être pseudo-aléatoire. La Fig. 2 montre l'histogramme correspondant des distances entre événements. Comme le registre 12 est formé de onze étages, il délivre successivement $2^{11}-1$ mots, donc 2 047 distances différentes par cycle du registre 12.

Si maintenant on laisse ouvert un interrupteur Jk, soit par exemple l'interrupteur J.5, chaque fois que le mot présent dans 12 comportera un bit de poids 5 égal à « 1 », le circuit 8 ne délivrera plus de signal quand le compteur 7 atteindra le complément à ce mot, mais quand il atteindra une autre valeur. On a donc interdit des distances entre événements dont les mots correspondants contiennent le bit de poids 5, pour en favoriser d'autres. En ouvrant plusieurs interrupteurs Jk, on supprime des coïncidences sur un certain nombre de poids. On dispose donc d'un moyen pour favoriser certaines distances entre événements au profit d'autres. La Fig. 3 montre l'histogramme des distances entre événements quand on a ouvert les interrupteurs J1 à J4 et J8 à J11. Il apparaît que les distances possibles ne sont conservées qu'entre 0 et 32 i. u., sans que le taux moyen d'occurrence des événements ait été modifié.

En pratique, le taux d'occurrence des événements peut être modifié en changeant de base de temps.

Dans le circuit 15, quand toutes les sorties Q sont à l'état « 1 », par exemple après une interruption de courant, la sortie de la porte ET 20 est à « 1 » tandis que la sortie du circuit 18 est à « 0 » puisque les sorties Q des bascules 12.9 et 12.11 sont à « 0 ». Donc, le circuit 19 à sa sortie à « 1 » ce qui provoque le démarrage du registre à décalage 12.

A la Fig. 4, on a représenté p générateurs élémentaires G1 à Gp, identiques au générateur de la Fig. 1, montés en cascade. La sortie 14 d'un générateur Gk étant reliée à l'entrée 3(k + 1) du générateur suivant, dans la cascade. Un circuit de sélection 22 permet de choisir dans la cascade un couple de sorties 14 et 21 d'un générateur, c'est-à-dire de faire un choix d'un taux moyen d'occurrence. Bien entendu, les interrupteurs Jk de ces générateurs sont à la disposition de l'opérateur pour faire varier les histogrammes des distances entre événements.

## Revendications

1. Générateur électronique d'événements comprenant une base de temps, un générateur de séquence aléatoire, un compteur (7) et un comparateur de mots (10, 8) dont une entrée de mot est reliée à la sortie de mot (M1, Mn) du générateur de séquence aléatoire (12, 15) et l'autre entrée de mot à la sortie de mot (S1, Sn) du compteur (7), la sortie du comparateur de mots (10, 8) étant reliée, d'une part, à l'entrée de remise à zéro du compteur (7) et, d'autre part, à l'entrée d'horloge du générateur de séquence aléatoire (12, 15), l'entrée d'horloge du compteur (7) étant reliée à la sortie de la base de temps, caractérisé en ce que le comparateur (10, 8) est formé d'un ensemble (10) de cellules (10.1 à 10.n) et d'une porte ET (8), le nombre des cellules (10.1 à 10.n) étant égal à la longueur du mot binaire de sortie du générateur de séquence aléatoire (12, 15), chaque cellule (10.k) comprenant une porte OU-exclusif (n.k) dont les deux entrées (P2k et P1k) sont respectivement reliées aux sorties des étages (7.k et 12.k) de même rang du générateur de séquence aléatoire et du compteur, la sortie de la porte OU-exclusif (n.k) étant reliée à une entrée d'une porte NON-ET (13.k) dont l'autre entrée est reliée à une source de potentiel par l'intermédiaire de contact de commutateur commandable (J.k) et dont la sortie est reliée à une entrée de la porte ET (8), commune à l'ensemble des cellules du comparateur, la sortie de ladite porte ET (8) constituant la sortie du générateur électronique d'événements.

2. Générateur suivant la revendication 1, caractérisé en ce que la base de temps est constituée par une base de temps proprement dite (1) dont la sortie est reliée à l'entrée d'un diviseur de fréquence (4) et comprend encore un circuit de commutation (5) pour sélecter des sorties dudit diviseur (4), une sortie (K2) du commutateur (5) étant reliée à l'entrée d'horloge du compteur (7) et à une entrée supplémentaire de ladite porte ET (8) du comparateur et une autre sortie (K1) étant reliée à l'entrée d'horloge d'une bascule (6) dont la sortie Q̄ est reliée à l'entrée de remise à zéro du compteur (7) et dont l'entrée D est reliée, par l'intermédiaire d'un inverseur (9), à la sortie de ladite porte ET (8).

3. Générateur électronique d'événements, caractérisé en ce qu'il se compose de générateurs suivant la revendication 2, montés en cascade, la sortie de l'un étant reliée à l'entrée du diviseur du suivant, et d'un circuit de sélection des sorties desdits générateurs.

## Claims

1. An electronic event generator with a time base, a pseudorandom sequence generator, a counter (7) and a word comparator (10, 8) one input of which is connected from the word output (M1, Mn) of the pseudo-random sequence generator (12, 15) and the other from the word ouput (S1, Sn) of the counter (7), the output of the word comparator (10, 8) being connected, on the one hand, to the reset input of the counter (7) and, on the other hand, to the clock input of the pseudo-random sequence generator (12, 15), the clock input of the counter (7) being connected from the output of the time base, characterized in that the word comparator (10, 8) is comprised of a plurality (10) of stages (10.1-10.n) and an AND gate (8), the number of stages (10.1-10.n) being equal to the length of the output binary word of the pseudo-random sequence generator (12, 15), each stage (10.k) including an exclusive OR gate (n.k) the two inputs of which (P2k and P1k) are respectively connected from the outputs of the stages (7.k and 12.k) having the same rank in the pseudo-random sequence generator as in the counter, the output of the exclusive OR gate (n.k) being connected to an input of a NAND gate (13.k), the other input of which is connected from a voltage source through a contact of a controllable switch (J.k) and the output of which is connected to an input of the AND gate (8) which is common to all the stages of the word comparator, the output of the said AND gate (8) being the electronic event generator output.

2. A generator according to claim 1, characterized in that the time base is constituted by a properly said time base (1) the output of which is connected to the input of a frequency divider (4) and further includes a switching circuit (5) for selecting outputs of said frequency divider (4), one output (K2) of the switching circuit (5) being connected to the clock input of the counter (7) and an additional input of said AND gate (8) of the comparator and the other output (K1) being connected to the clock input of a flip-flop (6) the output Q̄ of which is connected to the reset input of the counter (7) and the input D of which is connected, through an inverter (9), from the output of said AND gate (8).

3. An electronic event generator, characterized in that it is comprised of serially connected generators according to claim 2, the output of one generator being connected to the input of the frequency divider in the next succeeding generator and a circuit for selecting between the outputs of said generators.

**Patentansprüche**

1. Elektronischer Generator von Ereignissen mit einer Zeitbasis, einem Zufallfolgegenerator, einem Zähler (7) und einem Wort-Komparator (10, 8), dessen einer Worteingang mit dem Wortausgang (M1, Mn) des Zufallfolgegenerators, und dessen anderer Worteingang mit dem Wortausgang (S1, Sn) des Zählers (7) verbunden ist, wobei der Ausgang des Wort-Komparators (10, 8) einerseits mit dem Rückstelleingang des Zählers (7) und andererseits mit dem Takteingang des Zufallfolgegenerators (12, 15) verbunden ist, und wobei der Takteingang des Zählers (7) mit dem Ausgang der Zeitbasis verbunden ist, dadurch gekennzeichnet, daß der Komparator (10, 8) aus einer Anzahl (10) von Zellen (10.1 bis 10.n) und einem UND-Tor ET (8) gebildet ist, wobei die Anzahl der Zellen (10.1 bis 10.n) gleich der Länge des binären Ausgangswortes des Zufallfolgegenerators (12, 15) ist, daß jede Zelle ein Exklusiv-ODER-Tor (n.k) enthält, dessen beide Eingänge (P2k und P1k) jeweils mit den Ausgängen der Stufen (7.k und 12.k) verbunden sind, die in dem Zufallfolgegenerator denselben Rang haben wie in dem Zähler, daß der Ausgang des Exklusiv-ODER-Tors (n.k) mit einem Eingang eines NAND-Tors (13.k) verbunden ist, dessen anderer Eingang über einen Kontakt eines steuerbaren Umschalters (J.k) mit einer Spannungsquelle verbunden ist, und dessen Ausgang mit einem Eingang des UND-Tors ET (8) verbunden ist, das für alle Zellen des Komparators gemeinsam ist, und daß der Ausgang des genannten UND-Tors ET (8) den Ausgang des elektronischen Generators von Ereignissen bildet.

2. Generator nach Anspruch 1, dadurch gekennzeichnet, daß die Zeitbasis durch eine sogenannte Zeitbasis (1) gebildet wird, deren Ausgang mit dem Eingang eines Frequenzteilers (4) verbunden ist und ferner eine Umschalt-Schaltung (5) zum Auswählen der Ausgänge des genannten Teilers (4) enthält, daß ein Ausgang (K2) des Umschalters (5) mit dem Takteingang des Zählers (7) und einem zusätzlichen Eingang des genannten UND-Tors ET (8) des Komparators und ein anderer Ausgang (K1) mit dem Takteingang eines Flip-Flop (6) verbunden ist, dessen Ausgang (Q̄) mit dem Rückstelleingang des Zählers (7), und dessen Eingang (D) über einen Inverter (9) mit dem Ausgang des genannten UND-Tors ET (8) verbunden ist.

3. Elektronischer Generator von Ereignissen, dadurch gekennzeichnet, daß er aus in Reihe geschalteten Generatoren gemäß Anspruch 2 besteht, wobei der Ausgang eines Generators mit dem Eingang des Frequenzteilers in dem nächstfolgenden Generator verbunden ist, und daß eine Schaltung zur Auswahl zwischen den Ausgängen der genannten Generatoren vorgesehen ist.

**FIG.1**

0 071 511

0 071 511

# FIG.2

Nombre d'évènements

2   4   6   ···   4090  4092  4094

# FIG.3

Nombre d'évènements

1          2          16
1  2  16   1  2  16   1  2  16
0  2  4  32  256  288  3840  3872
32 i.u.   32 i.u.   32 i.u.

# FIG.4

22

21.1  3.2  21.2        3.p   21.p
G1        G2      ————   Gp
14.1      14.2              14.p

2